# EUROPEAN PATENT APPLICATION

(11) **EP 4 822 282 A2**
(43) Date of publication of application: **14.10.2026**
(21) Application number: 26196255.9
(22) Date of filing: 03.08.2026
(51) Int. Cl.: F28D 15/02

(54) **THERMAL COMPONENTS WITH A VARIED POROSITY WICK**

(30) Priority: 21.08.2025 US 202519306869
(71) Applicant: Apple Inc., Cupertino, CA 95014 (US)
(72) Inventor: TAN, Richard H., Cupertino, 95014 (US); AMBROSE, Jay, Cupertino, 95014 (US)
(74) Representative: Zacco Denmark A/S

(57) **Abstract**

A thermal component includes a wick with wick portions of different porosities. Based in part on the multiple wick portions, the thermal component forms a dual condenser thermal component. Also, based on the wick portions having different porosities, the wick portions may apply different capillary forces to a liquid therein. This may cause the liquid to flow at different speeds through different wick portions. This causes decreased liquid pressure drop in higher porosity wick portions. As a result, the liquid flow rate for a given maximum capillary pressure increases, thereby allowing the thermal component to increase the heat transport capabilities.

## Description

### TECHNICAL FIELD

This application is directed to thermal components in electronic devices, and more particularly, to thermal components with a wick in which the porosity of the wick structure(s) is different at different locations, thus forming a dual condenser thermal component.

### BACKGROUND

Thermal components, such as heat pipes, include a wick used to create capillary forces to transport fluid.

### BRIEF DESCRIPTION OF THE DRAWINGS

Certain features of the present disclosure are set forth in the appended claims. However, for purpose of explanation, several embodiments of the present disclosure are set forth in the following figures.
FIG. 1 illustrates a perspective view of an embodiment of an electronic device, in accordance with aspects of the present disclosure.
FIG. 2 illustrates a plan view of an embodiment of a thermal component for electronic devices, in accordance with aspects of the present disclosure.
FIG. 3 illustrates a cross sectional view of the thermal component shown in FIG. 2, taken along line 3-3, in accordance with aspects of the present disclosure.
FIG. 4 illustrates an enlarged view of a wick, showing various features of the wick, in accordance with aspects of the present disclosure.
FIG. 5 illustrates a plan view of a portion of an electronic device, showing the thermal component integrated with the electronic device, in accordance with aspects of the present disclosure.
FIG. 6 and FIG. 7 illustrate plan views of embodiments of thermal components, showing alternate shapes for thermal components, in accordance with aspects of the present disclosure.

### DETAILED DESCRIPTION

The detailed description set forth below is intended as a description of various configurations of the subject technology and is not intended to represent the only configurations in which the subject technology may be practiced. The appended drawings are incorporated herein and constitute a part of the detailed description. The detailed description includes specific details for the purpose of providing a thorough understanding of the subject technology. However, it will be clear and apparent to those skilled in the art that the subject technology is not limited to the specific details set forth herein and may be practiced without these specific details. In some instances, well-known structures and components are shown in block diagram form in order to avoid obscuring the concepts of the subject technology.

The present disclosure is directed to thermal components (e.g., heat pipes) in which the wick includes portions (e.g., locations, regions) of different porosity. A wick is an internal structure in the thermal component that is used to transport liquid from, for example, a condenser of the thermal component to an evaporator of the thermal component. The "porosity" or "porous region" refers to a void or voids in the wick. Wicks are formed via a sintering (e.g., heating) operation of metal particles or fibers without liquifying the metal particles or fibers. Moreover, traditional works provide a uniform porosity. However, thermal components described herein may include wick in which the porosity is non-uniform. For example, at some portions of the thermal component, the wick includes a greater porosity than that of another portion. This may be due to, for example, using powders (e.g., metal powders) of different sizes (e.g., different diameters), leading to different porous regions after the powders are combined (e.g., using the sintering operation). Based on having a non-uniform porosity, the wick may subject a fluid to different capillary forces. For example, at a portion in which the porosity is relatively lower, the capillary forces applied to the fluid may be relatively higher. As a result, the fluid may be transported through the wick at the low-porosity portion at a relatively higher rate. Beneficially, the liquid may return to a region (e.g., evaporator region) of the thermal component faster, leading to increased thermal transport capability.

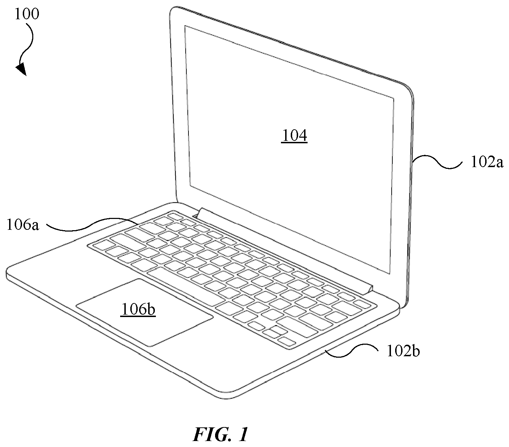

These and other embodiments are discussed below with reference to FIGS. 1-8. However, those skilled in the art will readily appreciate that the detailed description given herein with respect to these Figures is for explanatory purposes only and should not be construed as limiting.

FIG. 1 illustrates a perspective view of an embodiment of electronic device 100, in accordance with aspects of the present disclosure. In some embodiments, electronic device 100 takes the form of a mobile wireless communication device (e.g., smartphone, tablet computing device), a desktop computing device, a head-mounted device, or a video streaming device. In the embodiment shown in FIG. 1, electronic device 100 takes the form of a laptop computing device. Electronic device 100 includes housing part 102a and housing part 102b. Housing part 102a and housing part 102b may be referred to as a display housing (or simply, housing) and a base portion, respectively.

Housing part 102a is designed to carry display 104, which may present visual information in the form of text (e.g., words), still images, and/or motion images (e.g., video). Housing part 102b is designed to carry input mechanisms, such as input mechanism 106a and input mechanism 106b. In some embodiments, input mechanism 106a and input mechanism 106b take the form of a keyboard and a track pad, respectively. Using one or more of input mechanisms 106a and 106b, the visual information presented on display 104 may be altered. As shown, electronic device 100 is in an open position, thereby allowing a user to interact with electronic device 100. As shown, electronic device 100 is in an open position, thereby allowing a user to interact with electronic device 100. However, electronic device 100 may transition to a closed position but rotation of housing part 102a relative to housing part 102b.

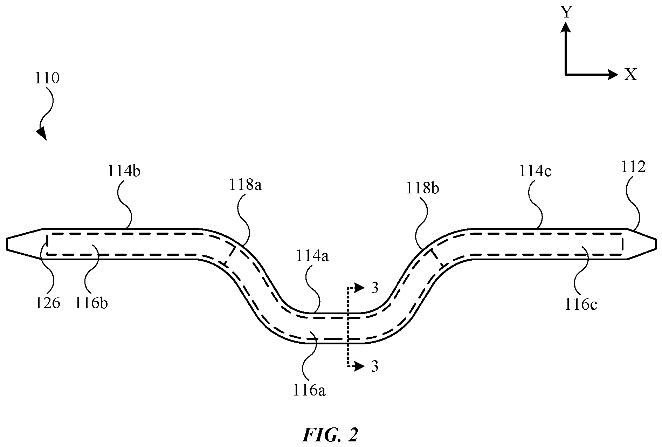

FIG. 2 illustrates a plan view of an embodiment of thermal component 110 for electronic devices, in accordance with aspects of the present disclosure. Thermal component 110 may be one of several thermal components disposed in an electronic device (e.g., electronic device 100 shown in FIG. 1). In one or more embodiments, thermal component 110 takes the form of a heat pipe. Thermal component 110 may include body 112. In one or more embodiments, body 112 is a metal body (e.g., copper, aluminum, or metal alloy). Thermal component 110 is designed to transport thermal energy (e.g., heat) by, for example, receiving thermal energy from a heat-generating, electrical component (not shown in FIG. 2) and transporting the thermal energy through body 112 to another location.

Thermal component 110 may include body portion 114a, body portion 114b, and body portion 114c. Body portion 114a (positioned between body portion 114b and body portion 114c) may be characterized as an evaporator section in which thermal energy is received by, for example, thermal conduction and transported away via a liquid (e.g., water vapor). Each of body portions 114b and 114c may be characterized as a condenser section in which thermal energy is received via the liquid (e.g., water vapor) from body portion 114a. In this regard, thermal component 110 may be characterized as a multi-condenser (e.g., dual condenser) thermal component. The thermal energy at each of body portions 114b and 114c may be transported away via thermal convection using, for example, a blower (not shown in FIG. 2).

In order to return the liquid from body portions 114b and 114c to body portion 114a, thermal component 110 may include wick 126. In one or more embodiments, wick 126 is formed by a sintering operation to a powder (e.g., metal powder). Once sintered, the resulting structure may include several pores through which the liquid is transported. Also, the size/volume of the pores may apply a force (e.g., capillary force) to the liquid, thus causing the liquid to move through the pores of wick 126.

Wick 126 may be defined by wick portion 116a, wick portion 116b, and wick portion 116c. As shown, wick portion 116a, wick portion 116b, and wick portion 116c may be carried by body portion 114a, body portion 114b, and body portion 114c, respectively. Some of the wick portions 116a, 116b, and 116c may be characterized by different wick portions of different porosities, resulting in wick 126 having a non-uniform porosity. For example, the porosity of wick portion 116a (positioned between wick portion 116b and wick portion 116c) may be include a porosity that is less than that of each of wick portions 116b and 116c. In this regard, the powder particles used to form wick portion 116a may be, on average, smaller than those used to form wick portions 116b and 116c. In one or more embodiments, the powder particles used to form wick portion 116b may be, on average, the same or similar to those used to form wick portion 116c. This will be discussed in further detail below. Also, in one or more embodiments, the transition from wick portion 116a to each of wick portions 116b and 116c may represent a gradual transition.

Thermal component 110 may take the form of various shapes. As shown in FIG. 2, thermal component 110 may be characterized as having a bullhorn shape. In this regard, body portion 114a (or a least a portion of body portion 114a) may be parallel with respect to body portion 114b and may also be parallel with respect to body portion 114c. Additionally, body portion 114b may also be co-linear with respect to body portion 114c such that body portions 114b and 114c may lie on the same horizontal line (e.g., a line parallel with respect to the X axis of Cartesian coordinates).

Also, body portion 114a and wick portion 116a may transition to body portion 114b and wick portion 116b, respectively, at curved region 118a of body 112. Similarly, body portion 114a and wick portion 116a may also transition to body portion 114c and wick portion 116c, respectively, at curved region 118b of body 112.

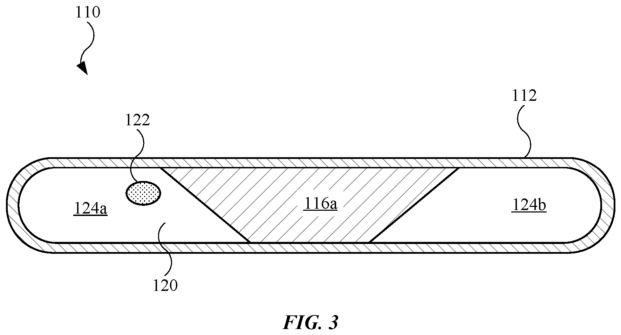

FIG. 3 illustrates a cross sectional view of thermal component 110 shown in FIG. 2, taken along line 3-3, in accordance with aspects of the present disclosure. As shown, body 112 defines internal volume 120 that allows body 112 to carry wick portion 116a (as well as wick portions 116b and 116b shown in FIG. 2) and vapor 122 (e.g., water in gaseous form), and also form void 124a and void 124b. Although vapor 122 is shown only in void 124a, additional liquid may also be in void 12rb. During operation of thermal component 110, thermal energy may be carried by vapor 122 via void 124a and/or void 124b to, for example, one of body portions 114b or 114c (e.g., condenser) shown in FIG. 2. When the thermal energy is removed, the vapor 122 may change from vapor form to liquid form, and the vapor 122 in liquid form is returned back via the wick portion 116b or wick portion 116c to wick portion 116a.

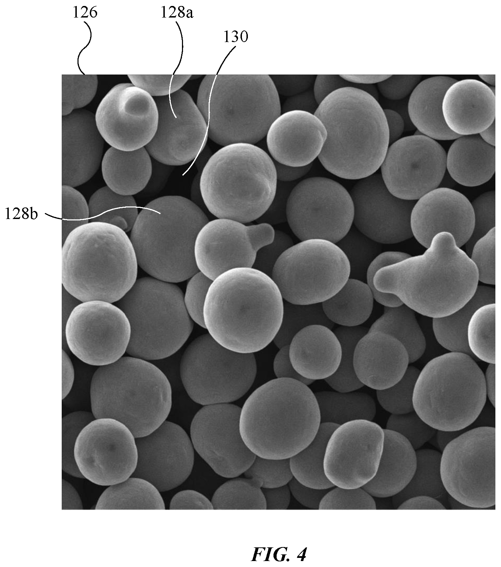

FIG. 4 illustrates an enlarged view of wick 126, showing various features of wick 126, in accordance with aspects of the present disclosure. As shown, wick 126 includes particle 128a and particle 128b. Each of particles 128a and 128b may take the form of a metal particle. Particles 128a and 128b may be coupled (e.g., indirectly coupled via other similar particles) to each other subsequent to a sintering operation. Also, as a result of the sintering operation, several pores (e.g., voids, spaces) between two or more particles may be formed. For example, pore 130 is formed between particles 128a and 128b (as well as between additional particles). The total pores, including pore 130, may represent the porosity of wick 126.

Pore 130 may represent a location through which liquid may pass. Pore 130 may apply (e.g., impart, exert) a force (e.g., capillary force) on the liquid. In this regard, the capillary force applied to the liquid in wick 126 may be indirectly proportional to the porosity of wick 126. Accordingly, a small porosity wick having a relatively smaller area or relatively smaller volume than that of a large porosity wick will apply a greater capillary force than that of the large porosity wick.

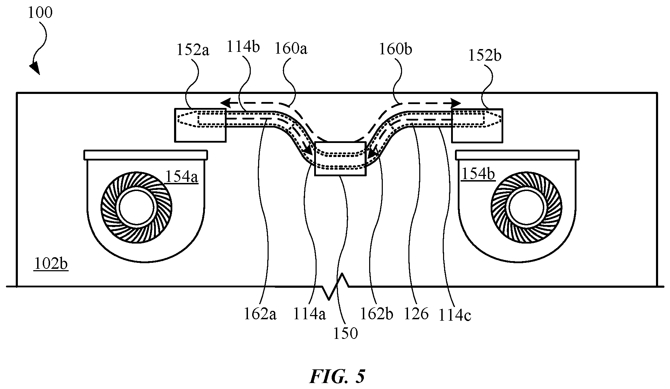

FIG. 5 illustrates table 140 showing values for portions of the wick, in accordance with aspects of the present disclosure. As shown, wick portion 116a may include 55% porosity and each of wick portions 116b and 116c may include 70% porosity. Put another way, 55% of wick portion 116a is porous and include no particles, while 45% of wick portion 116a is composed of metal particles. Similarly, 70% of each of wick portions 116b and 116c may be porous and include no particles, while 30% of each of wick portions 116b and 116c is composed of metal particles. In one or more embodiments, the porosity values are representative values in a range of porosities. For example, the porosity of wick portion 116a may be approximately in the range of 50% to 60%, while the porosity of each of wick portions 116b and 116c may be approximately in the range of 65 to 75%. Thus, the porosity of wick portion 116a may be nonoverlapping with respect to the porosity of wick portion 116b and 116c.

To achieve different porosities, at least some of wick portions 116a, 116b, and 116c may include a different distribution of particles (e.g., particles with different ranges of masses and/or sizes/diameters). For example, wick portion 116a may include a particle distribution of 75% particles having a diameter less than 100 micrometers (µm), and 25% particles having a diameter less than 200 µm. Conversely, each of wick portions 116b and 116c may include a particle distribution of 10% particles having a diameter less than 100 µm and 90% particles having a diameter less than 200 µm. Thus, due to the particle distribution of wick portion 116a having a higher percentage of particles with smaller diameters, wick portion 116a has a relatively smaller average particle diameter than that of either of wick portions 116b and 116c. Put another way, the ranges of particle diameters in wick portion 116a are skewed toward smaller diameters than those of each of wick portions 116b and 116c.

Additionally or alternatively to powder particles, wicks (including wick 126 shown in FIG. 4) may include non-powder/particle shapes such as wire/fibers. In addition to the size and shape of the selected particles, the porosity may also be affected by additives (e.g., sacrificial additives, foaming agents) used in the processing, which are vaporized during sintering, resulting in differing porosities in different regions.

Referring again to FIG. 2, based on the porosity of wick portion 116a being less than that of each of wick portions 116b and 116c, liquid passing through wick portion 116a may undergo a higher capillary force than when passing through either of wick portions 116b and 116c. As a result, the liquid may pass through wick portion 116a at a higher speed than that of either of wick portions 116b and 116c. When the liquid is returning through the wick and passes from wick portion 116b (or wick portion 116c) to wick portion 116a, the liquid may return to body portion 114a (e.g., evaporator section) at a higher speed based on the relatively smaller porosity of wick portion 116a, thus allowing the liquid to again begin receiving thermal energy at body portion 114a. Beneficially, the increased liquid return to body portion 114a may increase the heat transfer capability of thermal component 110, as compared to thermal components with a uniform porosity.

FIG. 5 illustrates a plan view of a portion of electronic device 100, showing thermal component 110 integrated with electronic device 100, in accordance with aspects of the present disclosure. As shown, electronic device 100 may include thermal component 110 disposed in housing part 102b. However, thermal component 110 (as well as other components to be discussed below) may be disposed in housing part 102a (shown in FIG. 2). Electronic device 100 may further heat-generating component 150, which may be representative of one or more heat-generating components. Although not shown, heat-generating component 150 may be disposed on a circuit board. In one or more embodiments, heat-generating component 150 takes the form of an integrated circuit (e.g., central processing unit, graphics processing unit, system on chip (SOC), or a combination thereof). As shown, heat-generating component 150 is disposed over body portion 114a. Accordingly, heat-generating component 150 is disposed over wick portion 116a (shown in FIG. 2). Based on the location relative to heat-generating component 150, thermal component 110 is thermally coupled with heat-generating component 150.

Electronic device 100 may further include thermal component 152a and thermal component 152b thermally coupled with thermal component 110 at body portion 114b and at body portion 114c, respectively. In one or more embodiments, each of thermal components 152a and 152b takes the form of a fin stack. As shown, thermal component 152a and thermal component 152b are disposed over body portion 114b and body portion 114c, respectively. However, in other embodiments (not shown), body portion 114b and body portion 114c are disposed over thermal component 152a and thermal component 152b, respectively. Additionally, electronic device 100 may include blower 154a and blower 154b. In one or more embodiments, each of blowers 154a and 154b takes the form of a fan.

During operation, heat-generating component 150 may generate thermal energy, at least some of which is received by thermal component 110. This may cause liquid (not shown in FIG. 5) to transition from liquid form to vapor form, with the resulting vapor moving (as denoted by arrow 160a and arrow 160b) from body portion 114a of thermal component 110 to one or more of body portions 114b and 114c of thermal component 110. The thermal energy may be extracted from the vapor via forced convection using thermal components 152a and 152b and blowers 154a and 154b. Accordingly, blowers 154a and 154b may be used to convectively remove thermal energy that is initially received by thermal component 110. Subsequently, the vapor may condense and return to liquid form, where the liquid is then transported back (as denoted by arrow 162a and arrow 162b) to body portion 114a of thermal component 110 via wick 126. In this regard, thermal component 110 not only provides dual condensers (e.g., at body portions 114b and 114c) but also transports liquid back at a higher speed with the liquid moves from wick portions 116b and 116c (shown in FIG. 2) to wick portion 116a (shown in FIG. 2).

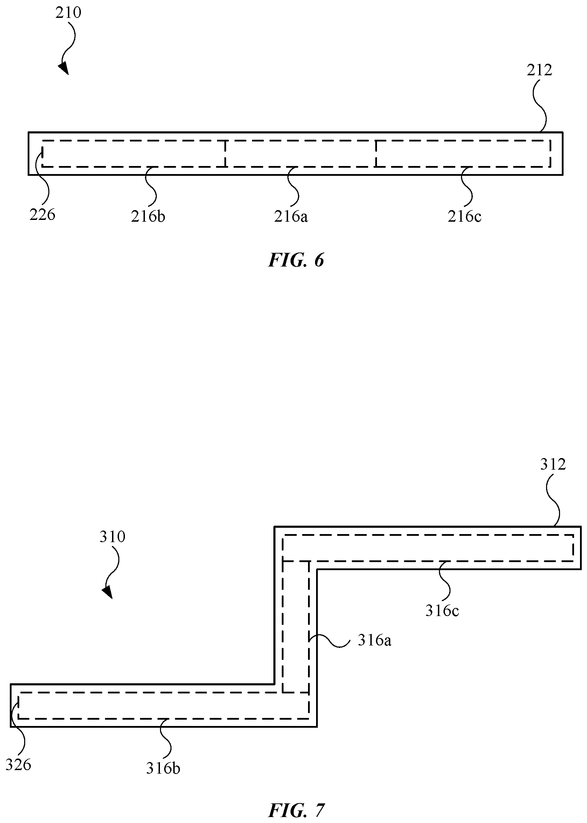

FIG. 6 and FIG. 7 illustrate plan views of embodiments of thermal components, showing alternate shapes for thermal components, in accordance with aspects of the present disclosure. The different shapes of thermal components are not intended to be limiting, and are representative of various additional shapes for a thermal component. Referring to FIG. 6, thermal component 210 may include body 212 that is generally straight or linear. Thermal component 210 may include wick 226 that includes wick portion 216a, wick portion 216b, and wick portion 216c. Wick portions 216a, 216b, and 216c may include the same or similar porosities as those of wick portions 116a, 116b, and 116c (shown in FIG. 2). Accordingly, wick portion 216a may apply a greater force (e.g., capillary force) to a liquid (not shown in FIG. 6), as compared to either of wick portions 216b and 216c. Also, wick portion 216a is between wick portion 216b and wick portion 216c.

Referring to FIG. 7, thermal component 310 may include body 312 that includes a step shape. Thermal component 310 may include wick 326 that includes wick portion 316a, wick portion 316b, and wick portion 316c. Wick portions 316a, 316b, and 316c may include the same or similar porosities as those of wick portions 116a, 116b, and 116c (shown in FIG. 2). Accordingly, wick portion 316a may apply a greater force (e.g., capillary force) to a liquid (not shown in FIG. 7), as compared to either of wick portions 316b and 316c. Also, wick portion 316a is between wick portion 316b and wick portion 316c.

Various examples of aspects of the disclosure are described below as clauses for convenience. These are provided as examples, and do not limit the subject technology.

Clause A: A thermal component, including: a body including an internal volume; and a wick disposed in the internal volume, the wick including: a first wick portion including a first porosity, a second wick portion including a second porosity different from the first porosity.

Clause B: A thermal component, including: a body including an internal volume; and a wick disposed in the internal volume, the wick including: a second wick portion configured to provide a second capillary force to the liquid, the second capillary force different from the first capillary force.

Clause C: A thermal component, including: a body including an internal volume; and a wick disposed in the internal volume, the wick including: a second wick portion configured to provide a second capillary force to the liquid, the second capillary force different from the first capillary force.

One or more of the above clauses can include one or more of the features described below. It is noted that any of the following clauses may be combined in any combination with each other, and placed into a respective independent clause, e.g., clause A, B, or C.

Clause 1: wherein: the first porosity is defined by a first distribution of particles that forms the first wick portion, and the second porosity is defined by a second distribution of particles that forms the second wick portion.

Clause 2: wherein the first porosity is less than the second porosity.

Clause 3: further including a third wick portion including the first porosity, wherein the first wick portion is positioned between the second wick portion and the third wick portion.

Clause 4: wherein the body includes: a first body portion that carries the first wick portion, the first body portion defining an evaporator; a second body portion that carries the second wick portion, the second body portion defining a first condenser; and a third body portion that carries the third wick portion, the third body portion defining a second condenser.

Clause 5: wherein: the first wick portion is configured to provide a first capillary force to a liquid, and the second wick portion configured to provide a second capillary force to the liquid, the second capillary force different from the first capillary force.

Clause 6: wherein the third wick portion is configured to provide the first capillary force to the liquid.

Clause 7: wherein the second capillary force is greater than the first capillary force.

Clause 8: wherein the second wick portion is coupled with the first wick portion and with the third wick portion.

Clause 9: wherein: the first wick portion includes a first porosity, and the second wick portion includes a second porosity different from the first porosity.

Clause 10: wherein the wick further includes a third wick portion configured to provide the first second force to the liquid.

Clause 11: wherein the third wick portion includes the first porosity.

Clause 12: wherein: the body further includes: a first body portion that carries the first wick portion in the internal volume, and a second body portion that carries the second wick portion in the internal volume, and the first body portion is parallel with respect to the second body portion.

Clause 13: wherein: the body further includes a third body portion that carries the third wick portion in the internal volume, and the first body portion is parallel with respect to the third body portion.

Clause 14: wherein the second body portion is co-linear with respect to the third body portion.

Clause 15: further including a blower configured to convectively cool the second thermal component.

Clause 16: wherein the wick further includes a third wick portion including the first porosity.

Clause 17: wherein: the first porosity is defined by a first distribution of particles that forms the first wick portion, and the second porosity is defined by a second distribution of particles that forms the second wick portion.

It is well understood that the use of personally identifiable information should follow privacy policies and practices that are generally recognized as meeting or exceeding industry or governmental requirements for maintaining the privacy of users. In particular, personally identifiable information data should be managed and handled so as to minimize risks of unintentional or unauthorized access or use, and the nature of authorized use should be clearly indicated to users.

As used herein, the phrase "at least one of" preceding a series of items, with the term "and" or "or" to separate any of the items, modifies the list as a whole, rather than each member of the list (i.e., each item). The phrase "at least one of" does not require selection of at least one of each item listed; rather, the phrase allows a meaning that includes at least one of any one of the items, and/or at least one of any combination of the items, and/or at least one of each of the items. By way of example, the phrases "at least one of A, B, and C" or "at least one of A, B, or C" each refer to only A, only B, or only C; any combination of A, B, and C; and/or at least one of each of A, B, and C.

The predicate words "configured to", "operable to", and "programmed to" do not imply any particular tangible or intangible modification of a subject, but, rather, are intended to be used interchangeably. In one or more implementations, a processor configured to monitor and control an operation or a component may also mean the processor being programmed to monitor and control the operation or the processor being operable to monitor and control the operation. Likewise, a processor configured to execute code can be construed as a processor programmed to execute code or operable to execute code.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

Phrases such as an aspect, the aspect, another aspect, some aspects, one or more aspects, an implementation, the implementation, another implementation, some implementations, one or more implementations, an embodiment, the embodiment, another embodiment, some embodiments, one or more embodiments, a configuration, the configuration, another configuration, some configurations, one or more configurations, the subject technology, the disclosure, the present disclosure, other variations thereof and alike are for convenience and do not imply that a disclosure relating to such phrase(s) is essential to the subject technology or that such disclosure applies to all configurations of the subject technology. A disclosure relating to such phrase(s) may apply to all configurations, or one or more configurations. A disclosure relating to such phrase(s) may provide one or more examples. A phrase such as an aspect or some aspects may refer to one or more aspects and vice versa, and this applies similarly to other foregoing phrases.

The word "exemplary" is used herein to mean "serving as an example, instance, or illustration". Any embodiment described herein as "exemplary" or as an "example" is not necessarily to be construed as preferred or advantageous over other embodiments. Furthermore, to the extent that the term "include", "have", or the like is used in the description or the claims, such term is intended to be inclusive in a manner similar to the term "comprise" as "comprise" is interpreted when employed as a transitional word in a claim.

All structural and functional equivalents to the elements of the various aspects described throughout this disclosure that are known or later come to be known to those of ordinary skill in the art are expressly incorporated herein by reference and are intended to be encompassed by the claims. Moreover, nothing disclosed herein is intended to be dedicated to the public regardless of whether such disclosure is explicitly recited in the claims. No claim element is to be construed under the provisions of 35 U.S.C. § 112, sixth paragraph, unless the element is expressly recited using the phrase "means for" or, in the case of a method claim, the element is recited using the phrase "step for".

The previous description is provided to enable any person skilled in the art to practice the various aspects described herein. Various modifications to these aspects will be readily apparent to those skilled in the art, and the generic principles defined herein may be applied to other aspects. Thus, the claims are not intended to be limited to the aspects shown herein, but are to be accorded the full scope consistent with the language claims, wherein reference to an element in the singular is not intended to mean "one and only one" unless specifically so stated, but rather "one or more". Unless specifically stated otherwise, the term "some" refers to one or more. Pronouns in the masculine (e.g., his) include the feminine and neuter gender (e.g., her and its) and vice versa. Headings and subheadings, if any, are used for convenience only and do not limit the subject disclosure.

Exemplary thermal components and electronic devices are set out in the following items.
1. A thermal component, comprising:
   a body comprising an internal volume; and
   a wick disposed in the internal volume, the wick comprising:
      a first wick portion comprising a first porosity,
      a second wick portion comprising a second porosity different from the first porosity.
2. The thermal component of item 1, wherein:
   the first porosity is defined by a first distribution of particles that forms the first wick portion, and
   the second porosity is defined by a second distribution of particles that forms the second wick portion.
3. The thermal component of item 2, wherein the first porosity is less than the second porosity.
4. The thermal component of item 2, further comprising a third wick portion comprising the first porosity, wherein the first wick portion is positioned between the second wick portion and the third wick portion.
5. The thermal component of item 4, wherein the body comprises:
   a first body portion that carries the first wick portion, the first body portion defining an evaporator;
   a second body portion that carries the second wick portion, the second body portion defining a first condenser; and
   a third body portion that carries the third wick portion, the third body portion defining a second condenser.
6. The thermal component of item 4, wherein:
   the first wick portion is configured to provide a first capillary force to a liquid, and
   the second wick portion configured to provide a second capillary force to the liquid, the second capillary force different from the first capillary force.
7. The thermal component of item 6, wherein the third wick portion is configured to provide the first capillary force to the liquid.
8. The thermal component of item 7, wherein the second capillary force is greater than the first capillary force.
9. The thermal component of item 4, wherein the second wick portion is coupled with the first wick portion and with the third wick portion.
10. A thermal component, comprising:
   a body comprising an internal volume; and
   a wick disposed in the internal volume, the wick comprising:
      a first wick portion configured to provide a first capillary force to a liquid, and
      a second wick portion configured to provide a second capillary force to the liquid, the second capillary force different from the first capillary force.
11. The thermal component of item 10, wherein:
   the first wick portion comprises a first porosity, and
   the second wick portion comprises a second porosity different from the first porosity.
12. The thermal component of item 11, wherein the wick further comprises a third wick portion configured to provide the first second force to the liquid.
13. The thermal component of item 12, wherein the third wick portion comprises the first porosity.
14. The thermal component of item 12, wherein:
   the body further comprises:
   a first body portion that carries the first wick portion in the internal volume, and
   a second body portion that carries the second wick portion in the internal volume, and
   the first body portion is parallel with respect to the second body portion.
15. The thermal component of item 14, wherein:
   the body further comprises a third body portion that carries the third wick portion in the internal volume, and
   the first body portion is parallel with respect to the third body portion.
16. The thermal component of item 15, wherein the second body portion is co-linear with respect to the third body portion.
17. An electronic device, comprising:
   an integrated circuit configured to generate thermal energy;
   a first thermal component thermal coupled with the integrated circuit, the first thermal component comprising:
      a body comprising an internal volume; and
      a wick disposed in the internal volume, the wick comprising:
         a first wick portion comprising a first porosity,
         a second wick portion comprising a second porosity different from the first porosity, wherein the integrated circuit is disposed over the first wick portion; and
   a second thermal component thermally coupled with the first thermal component, the second thermal component disposed over the second wick portion and configured to receive at least some of the thermal energy that is received via the first thermal component.
18. The electronic device of item 17, further comprising a blower configured to convectively cool the second thermal component.
19. The electronic device of item 17, wherein the wick further comprises a third wick portion comprising the first porosity.
20. The electronic device of item 19, wherein:
   the first porosity is defined by a first distribution of particles that forms the first wick portion, and
   the second porosity is defined by a second distribution of particles that forms the second wick portion.

The foregoing description, for purpose of explanation, has been described with reference to specific embodiments. However, the illustrative discussions above are not intended to be exhaustive or to limit the invention to the precise forms disclosed. Many modifications and variations are possible in view of the above teachings. The embodiments were chosen and described in order to best explain the principles of the invention and its practical applications, to thereby enable others skilled in the art to best utilize the invention and various embodiments with various modifications as are suited to the particular use contemplated.

## Claims

1. A thermal component, comprising:
a body comprising an internal volume; and
a wick disposed in the internal volume, the wick comprising:
a first wick portion comprising a first porosity,
a second wick portion comprising a second porosity different from the first porosity.

2. The thermal component of claim 1, wherein:
the first porosity is defined by a first distribution of particles that forms the first wick portion, and
the second porosity is defined by a second distribution of particles that forms the second wick portion.

3. The thermal component of claim 2, wherein the first porosity is less than the second porosity.

4. The thermal component of claim 2, further comprising a third wick portion comprising the first porosity, wherein the first wick portion is positioned between the second wick portion and the third wick portion.

5. The thermal component of claim 4, wherein the body comprises:
a first body portion that carries the first wick portion, the first body portion defining an evaporator;
a second body portion that carries the second wick portion, the second body portion defining a first condenser; and
a third body portion that carries the third wick portion, the third body portion defining a second condenser.

6. The thermal component of claim 4, wherein:
the first wick portion is configured to provide a first capillary force to a liquid, and
the second wick portion configured to provide a second capillary force to the liquid, the second capillary force different from the first capillary force.

7. The thermal component of claim 6, wherein the third wick portion is configured to provide the first capillary force to the liquid.

8. The thermal component of claim 7, wherein the second capillary force is greater than the first capillary force.

9. The thermal component of claim 4, wherein the second wick portion is coupled with the first wick portion and with the third wick portion.

10. The thermal component of any of the preceding claims, wherein:
the first wick portion is configured to provide a first capillary force to a liquid, and
the second wick portion is configured to provide a second capillary force to the liquid, the second capillary force being different from the first capillary force.

11. The thermal component of claim 10, wherein:
the first wick portion comprises a first porosity, and
the second wick portion comprises a second porosity different from the first porosity.

12. The thermal component of claim 11, wherein the wick further comprises a third wick portion configured to provide the first capillary force to the liquid.

13. The thermal component of claim 12, wherein the third wick portion comprises the first porosity.

14. The thermal component of claim 12, wherein:
the body further comprises:
a first body portion that carries the first wick portion in the internal volume, and
a second body portion that carries the second wick portion in the internal volume,
wherein the first body portion is parallel with respect to the second body portion.

15. The thermal component of claim 14, wherein:
the body further comprises a third body portion that carries the third wick portion in the internal volume, and
the first body portion is parallel with respect to the third body portion.
